# EUROPÄISCHE PATENTSCHRIFT

(11) **EP 3 922 088 B1**
(45) Veröffentlichungstag und Bekanntmachung des Hinweises auf die Patenterteilung: **27.07.2022**
(21) Anmeldenummer: 20711553.6
(22) Anmeldetag: 11.03.2020
(51) Int. Cl.: H05K 7/14

(54) **SCHALTSCHRANKSYSTEM MIT DICHTUNGSEINSATZ**
SWITCH CABINET SYSTEM WITH SEALING INSERT
SYSTÈME D'ARMOIRE ÉLECTRIQUE AVEC PIÈCE D'ÉTANCHÉITÉ

(30) Priorität: 11.03.2019 DE 102019106082
(43) Veröffentlichungstag der Anmeldung: 15.12.2021
(73) Patentinhaber: Beckhoff Automation GmbH, 33415 Verl (DE)
(72) Erfinder: BECKHOFF, Hans, 33415 Verl (DE); WITTENBORG, Peter, 33415 Verl (DE); SIEGENBRINK, Daniel, 33617 Bielefeld (DE)
(74) Vertreter: Patentanwaltskanzlei WILHELM & BECK
(86) Internationale Anmeldenummer: PCT/EP2020/056494
(87) Internationale Veröffentlichungsnummer: WO 2020/182877

(56) Entgegenhaltungen:
- DE-A1- 10 006 879
- DE-A1-102004 018 115
- US-A1- 2005 185 381

## Beschreibung

Die vorliegende Erfindung betrifft ein Schaltschranksystem mit einem Dichtungseinsatz.

Ein Schaltschranksystem umfasst elektrische und/oder elektronische Komponenten eines Automatisierungssystems. Ein Schaltschranksystem fungiert als Verteilersystem. Beispielsweise können elektrische Spannungen vom Schaltschranksystem verteilt und Feldgeräten eines Automatisierungssystems bereitgestellt werden. Ein Automatisierungssystem kann beispielsweise in einer Produktionsmaschine zum Einsatz kommen.

Diese Anmeldung beansprucht die Priorität der deutschen Patentanmeldung

DE 10 2019 106 082.6 mit dem Titel "SCHALTSCHRANKSYSTEM MIT DICHTUNGSEINSATZ", eingereicht am 11. März 2019. Der Offenbarungsgehalt der Prioritätsanmeldung DE 10 2019 106 082.6 wird durch Rückbezug ausdrücklich auch zum Inhalt der vorliegenden Anmeldung gemacht.

Aus der DE 100 06 879 A1 ist eine modulare Steuerungsanlage für Steuerungs- und Automatisierungssysteme mit einem Basismodul, das mit Funktionsmodulen bestückt werden kann, bekannt. Eine Schnittstelle zwischen Basisplatte und einem Modulgehäuse liegt innerhalb eines Dichtrings, der zwischen dem Basismodul und einer Anlagefläche des aufgesteckten Funktionsmoduls abdichtet. Ein Nachteil dieses Dichtungskonzepts besteht darin, dass es nicht redundant ausgebildet ist.

Druckschrift US 2005/185381 A1 zeigt ein Gehäuse für eine elektronische Einheit, bei dem ein Deckel an eine Wandung geflanscht ist. Zwischen dem Deckel und der Wandungen ist eine Metallplatte angeordnet. Zwischen dem Deckel und der Metallplatte ist eine erste Dichtung angeordnet. Zwischen der Metallplatte und der Wandung ist eine zweite Dichtung angeordnet.

Druckschrift DE 10 2004 018 115 A1 zeigt eine Baugruppe mit mindestens zwei Teilkomponenten. Um die Austauschbarkeit von Dichtungen zu verbessern, wird vorgeschlagen, dass die Baugruppe mindestens ein Dichtungsmodul zur Aufnahme mindestens einer Dichtung aufweist, welches zwischen jeweils zwei Teilkomponenten einsetzbar ist

Eine Aufgabe der vorliegenden Erfindung besteht darin, ein verbessertes Schaltschranksystem mit einem Dichtungseinsatz, ein verbessertes Funktionsmodul mit einem Dichtungseinsatz und einen Dichtungseinsatz bereitzustellen. Diese Aufgaben werden durch ein Schaltschranksystem mit einem Dichtungseinsatz, ein Funktionsmodul mit einem Dichtungseinsatz und einen Dichtungseinsatz mit den Merkmalen der unabhängigen Ansprüche gelöst. Vorteilhafte Weiterbildungen sind in abhängigen Ansprüchen angegeben.

Ein Schaltschranksystem weist ein Basismodul und zumindest ein Funktionsmodul auf. Das Funktionsmodul weist ein Funktionsgehäuse auf. Das Funktionsgehäuse weist an einer Unterseite eine erste Durchgangsöffnung auf. Ein Funktionsanschlusselement des Funktionsmoduls ist im Funktionsgehäuse und im Bereich der ersten Durchgangsöffnung angeordnet. Das Basismodul weist ein Basisgehäuse auf. Das Basisgehäuse weist an einer Oberseite eine zweite Durchgangsöffnung auf. Ein Basisanschlusselement des Basismoduls ist im Basisgehäuse und im Bereich der zweiten Durchgangsöffnung angeordnet. Das Funktionsgehäuse liegt mit der Unterseite an der Oberseite des Basisgehäuses an. Das Funktionsanschlusselement und das Basisanschlusselement greifen ineinander und bilden eine Schnittstelle. Das Schaltschranksystem weist einen Dichtungseinsatz mit einem Rahmen auf. Der Rahmen des Dichtungseinsatzes weist einen in das Funktionsgehäuse eingreifenden Funktionsabschnitt und einen in das Basisgehäuse eingreifenden Basisabschnitt auf. Der Funktionsabschnitt des Rahmens liegt an einer Innenwandung des Funktionsgehäuses an. Der Basisabschnitt des Rahmens liegt an einer die zweite Durchgangsöffnung umgrenzenden Wandung des Basisgehäuses an.

Vorteilhafterweise kann das Schaltschranksystem durch den Dichtungseinsatz beispielsweise gegen das Eindringen von Feuchtigkeit und/oder Staubpartikeln geschützt sein, da der Funktionsabschnitt des Dichtungseinsatzes an der Innenwandung des Funktionsgehäuses anliegt und der Basisabschnitt des Dichtungseinsatzes an der die zweite Durchgangsöffnung umgrenzenden Wandung des Basisgehäuses anliegt, wodurch zwischen der Unterseite des Funktionsgehäuses und der Oberseite des Basisgehäuses eindringende Feuchtigkeit und/oder Partikel daran gehindert werden können, in das Schaltschranksystem zu gelangen. Das Schaltschranksystem kann somit beispielsweise die Schutzart IP67 erfüllen, d.h. das Schaltschranksystem kann staubdicht und vollständig gegen Berührung und gegen ein zeitweiliges Untertauchen geschützt sein. Dadurch können im Funktionsgehäuse und im Basisgehäuse angeordnete elektronische Komponenten vor einem Schaden bewahrt werden, wodurch ein Ausfall des Schaltschranksystems verhindert werden kann. Bei einem Einsatz des Schaltschranksystems kann das Schaltschranksystem deswegen in einer Umgebung angeordnet sein, in der das Schaltschranksystem feuchten und/oder staubigen Bedingungen ausgesetzt ist, ohne dass ein Ausfall des Schaltschranksystems zu befürchten ist. Eine solche Umgebung kann beispielsweise in der Nähe einer Produktionsmaschine vorliegen. Alternativ zur Schutzklasse IP67 kann das Schaltschranksystem auch die Schutzklasse IP69k erfüllen.

Dadurch, dass der Basisabschnitt des Rahmens in das Basismodul eingreift, bietet das Schaltschranksystem den zusätzlichen Vorteil der Führung des Funktionsmoduls und des Funktionsanschlusselements bei der Montage des Funktionsmoduls auf dem Basismodul. Hierdurch können bei der Montage auf das Funktionsanschlusselement wirkende Kräfte verringert werden. Darüber hinaus kann in einer nicht näher beschriebenen Ausführungsform beispielsweise eine Leiterplatte am Dichtungseinsatz befestigt werden. Damit kann der Dichtungseinsatz als Montagehilfe dienen, da die Leiterplatte und der Dichtungseinsatz gemeinsam im Funktionsmodul verbaut werden können.

Der Rahmen des Dichtungseinsatzes weist eine erste Nut und eine zweite Nut auf. Die erste Nut ist um den Funktionsabschnitt des Rahmens umlaufend und die zweite Nut um den Basisabschnitt des Rahmens umlaufend ausgebildet. Eine erste Dichtung ist in der ersten Nut angeordnet und liegt an der Innenwandung des Funktionsgehäuses an. Eine zweite Dichtung ist in der zweiten Nut angeordnet und liegt an der die zweite Durchgangsöffnung umgebenden Wandung des Basisgehäuses an.

Vorteilhafterweise kann durch die erste Dichtung verhindert werden, dass Feuchtigkeit und/oder Staubpartikel, die zwischen der Unterseite des Funktionsgehäuses und der Oberseite des Basisgehäuses in das Schaltschranksystem eindringen, in das Funktionsgehäuse gelangen. Durch die zweite Dichtung kann verhindert werden, dass Feuchtigkeit und/oder Staubpartikel, die zwischen der Unterseite des Funktionsgehäuses und der Oberseite des Basisgehäuses in das Schaltschranksystem eindringen, in das Basisgehäuse gelangen. Damit sind im Funktionsgehäuse und im Basisgehäuse angeordnete Elemente, wie beispielsweise Leiterplatten, gegen ein Eindringen von Feuchtigkeit und/oder Staubpartikeln zusätzlich geschützt.

Die die Unterseite des Funktionsgehäuses weist eine die erste Durchgangsöffnung umgrenzende dritte Nut auf. Eine dritte Dichtung ist in der dritten Nut angeordnet und liegt an der Oberseite des Basisgehäuses an.

Vorteilhafterweise kann die dritte Dichtung das Eindringen von Feuchtigkeit und/oder Staubpartikeln zwischen der Unterseite des Funktionsgehäuses und der Oberseite des Basisgehäuses in das Schaltschranksystem verhindern. Dadurch sind das Funktionsmodul und das Basismodul zusätzlich gegen ein Eindringen von Feuchtigkeit und/oder Staubpartikeln geschützt. In Kombination mit der ersten Dichtung und der zweiten Dichtung ist das Schaltschranksystem besonders gut gegenüber einem solchen Eindringen von Feuchtigkeit und/oder Staubpartikeln abgedichtet, da das Schaltschranksystem ein redundantes Dichtungskonzept aufweist: Sollte die dritte Dichtung undicht sein, können die erste Dichtung und die zweite Dichtung immer noch einen Schutz gegen ein Eindringen von Feuchtigkeit und/oder Staubpartikeln bieten. Somit stellt das Schaltschranksystem im Vergleich zum Stand der Technik eine erhöhte Sicherheit hinsichtlich des Dichtungskonzepts bereit.

In einer Ausführungsform des Schaltschranksystems weist der Dichtungseinsatz eine starr mit dem Rahmen verbundene Abdeckung auf. Die Abdeckung ist innerhalb eines vom Rahmen umgrenzten Bereichs angeordnet. Die Abdeckung weist eine Aussparung auf. Die Schnittstelle ist im Bereich der Aussparung angeordnet.

Vorteilhafterweise sind im Funktionsgehäuse angeordnete Komponenten des Funktionsmoduls durch die Abdeckung gegen Berührungen geschützt. Dies kann beispielsweise bei einer Erstmontage, einem Austausch oder einer Reparatur des Funktionsmoduls zweckmäßig sein, wenn das Funktionsmodul also von dem Basismodul getrennt wird.

In einer Ausführungsform des Schaltschranksystems weist die Abdeckung zumindest eine weitere Aussparung auf. Vorteilhafterweise ermöglicht die zumindest eine weitere Aussparung es, dass Wärme aus dem Funktionsgehäuse durch die weitere Aussparung in das Basisgehäuse abgeführt werden kann.

In einer Ausführungsform des Schaltschranksystems weist der Dichtungseinsatz zumindest zwei mit dem Rahmen starr verbundene Halteabschnitte auf. Die Halteabschnitte erstrecken sich in eine Richtung senkrecht zum Rahmen und ragen in das Funktionsgehäuse hinein. Die Halteabschnitte sind durch die weiteren Aussparungen zugänglich. Der Dichtungseinsatz ist an den Halteabschnitten am Funktionsgehäuse fixiert.

Vorteilhafterweise sind die Halteabschnitte durch die weiteren Aussparungen zugänglich, wodurch der Dichtungseinsatz beispielsweise mittels Schrauben an der Innenwandung des Funktionsgehäuses befestigt werden kann. Der an der Innenwandung des Funktionsgehäuses anliegende Abschnitt des Rahmens des Dichtungseinsatzes bildet den Funktionsabschnitt des Rahmens. Der außerhalb des Funktionsgehäuses angeordnete Abschnitt des Rahmens des Dichtungseinsatzes bildet den Basisabschnitt des Rahmens.

In einer Ausführungsform des Schaltschranksystems ragt das Funktionsanschlusselement nicht weiter aus dem Funktionsgehäuse heraus als der Rahmen des Dichtungseinsatzes. Vorteilhafterweise ist das Funktionsanschlusselement dadurch, dass es nicht weiter aus dem Funktionsgehäuse ragt als der Rahmen des Dichtungseinsatzes, gegen mechanische Einwirkungen geschützt.

Ein Funktionsmodul für ein Schaltschranksystem weist ein Funktionsgehäuse auf. Das Funktionsgehäuse weist an einer Unterseite eine erste Durchgangsöffnung auf. Ein Funktionsanschlusselement des Funktionsmoduls ist im Funktionsgehäuse und im Bereich der ersten Durchgangsöffnung angeordnet. Das Funktionsmodul weist einen Dichtungseinsatz mit einem Rahmen auf. Der Rahmen des Dichtungseinsatzes weist einen in das Funktionsgehäuse eingreifenden Funktionsabschnitt und einen außerhalb des Funktionsgehäuses angeordneten Basisabschnitt auf. Der Funktionsabschnitt des Rahmens liegt an einer Innenwandung des Funktionsgehäuses an. Vorteilhafterweise kann ein Schaltschranksystem beim Einsatz des Funktionsmoduls im Schaltschranksystem durch den Dichtungseinsatz beispielsweise gegen das Eindringen von Feuchtigkeit und/oder Staubpartikeln geschützt sein.

Der Rahmen des Dichtungseinsatzes weist eine erste Nut und eine zweite Nut auf. Die erste Nut ist um den Funktionsabschnitt des Dichtungseinsatzes umlaufend und die zweite Nut ist um den Basisabschnitt des Dichtungseinsatzes umlaufend ausgebildet. Eine erste Dichtung ist in der ersten Nut angeordnet und liegt an der Innenwandung des Funktionsgehäuses an. Eine zweite Dichtung ist in der zweiten Nut angeordnet. Vorteilhafterweise kann ein Schaltschranksystem beim Einsatz des Funktionsmoduls im Schaltschranksystem durch die erste und die zweite Dichtung zusätzlich gegen das Eindringen von Feuchtigkeit und/oder Staubpartikeln geschützt sein.

Die Unterseite des Funktionsgehäuses weist eine die erste Durchgangsöffnung umgrenzende dritte Nut auf. Eine dritte Dichtung ist in der dritten Nut angeordnet. Vorteilhafterweise kann ein Schaltschranksystem beim Einsatz des Funktionsmoduls im Schaltschranksystem durch die dritte Dichtung zusätzlich gegen das Eindringen von Feuchtigkeit und/oder Staubpartikeln geschützt sein.

In einer Ausführungsform des Funktionsmoduls weist der Dichtungseinsatz eine starr mit dem Rahmen verbundene Abdeckung auf. Die Abdeckung ist innerhalb eines vom Rahmen umgrenzten Bereichs angeordnet. Die Abdeckung weist eine Aussparung auf. Das Funktionsanschlusselement ist im Bereich der Aussparung angeordnet. Vorteilhafterweise sind im Funktionsgehäuse angeordnete Komponenten des Funktionsmoduls durch die Abdeckung gegen Berührungen geschützt.

In einer Ausführungsform des Funktionsmoduls weist die Abdeckung zumindest eine weitere Aussparung auf. Vorteilhafterweise ermöglicht die zumindest eine weitere Aussparung es, dass beim Einsatz des Funktionsmoduls in einem Schaltschranksystem Wärme aus dem Funktionsgehäuse durch die weitere Aussparung in ein Basisgehäuse des Schaltschranksystems abgeführt werden kann.

In einer Ausführungsform des Funktionsmoduls weist der Dichtungseinsatz zumindest zwei mit dem Rahmen starr verbundene Halteabschnitte auf. Die Halteabschnitte erstrecken sich in eine Richtung senkrecht zum Rahmen und ragen in das Funktionsgehäuse hinein. Die Halteabschnitte sind durch die weiteren Aussparungen zugänglich. Der Dichtungseinsatz ist an den Halteabschnitten am Funktionsgehäuse fixiert. Vorteilhafterweise sind die Halteabschnitte durch die weiteren Aussparungen zugänglich, wodurch der Dichtungseinsatz beispielsweise mittels Schrauben an der Innenwandung des Funktionsgehäuses befestigt werden kann.

In einer Ausführungsform des Funktionsmoduls ragt das Funktionsanschlusselement nicht weiter aus dem Funktionsgehäuse heraus als der Rahmen des Dichtungseinsatzes. Vorteilhafterweise ist das Funktionsanschlusselement dadurch, dass es nicht weiter aus dem Funktionsgehäuse ragt als der Rahmen des Dichtungseinsatzes, gegen mechanische Einwirkungen geschützt.

Die oben beschriebenen Eigenschaften, Merkmale und Vorteile dieser Erfindung sowie die Art und Weise, wie diese erreicht werden, sind klarer und deutlicher verständlich im Zusammenhang mit der folgenden Beschreibung der Ausführungsbeispiele, die im Zusammenhang mit den Zeichnungen näher erläutert werden. Dabei zeigen in jeweils schematischer Darstellung:
Fig. 1: ein Schaltschranksystem in einer perspektivischen Ansicht;
Fig. 2: eine Draufsicht auf einen Ausschnitt des Schaltschranksystems der Fig. 1;
Fig. 3a und 3b: verschiedene perspektivische Ansichten auf eine Unterseite eines Funktionsmoduls des Schaltschranksystems;
Fig. 4a und 4b: einen Dichtungseinsatz des Funktionsmoduls in verschiedenen perspektivischen Ansichten;
Fig. 5: eine perspektivische Querschnittsansicht auf das Schaltschranksystem;
Fig. 6: ein weiteres Funktionsmodul in einer perspektivischen Ansicht auf eine Unterseite auf das weitere Funktionsmodul; und
Fig. 7: einen weiteren Dichtungseinsatz für das weitere Funktionsmodul in einer perspektivischen Ansicht.

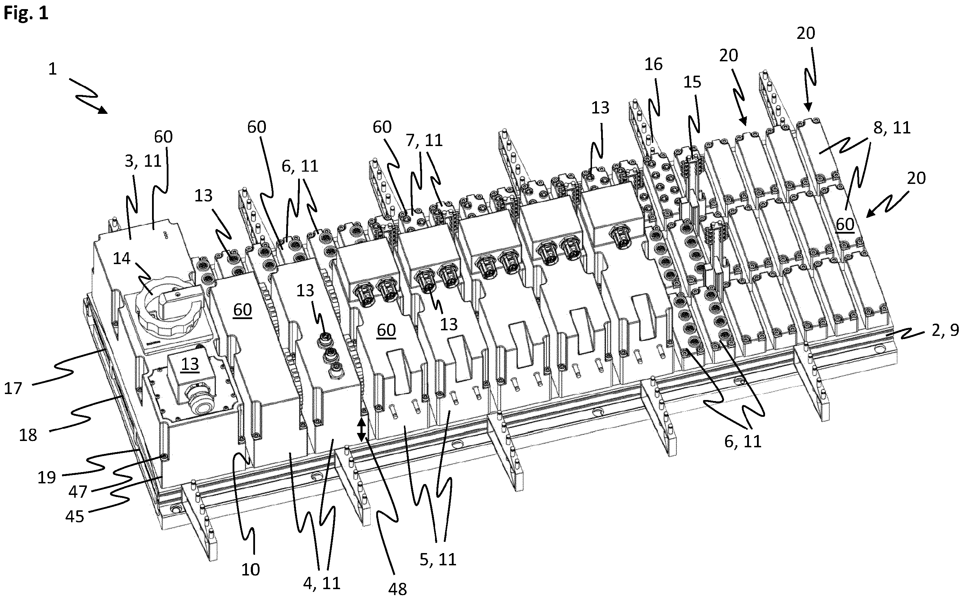

Fig. 1 zeigt schematisch ein beispielhaftes Schaltschranksystem 1 in einer perspektivischen Ansicht.

Das Schaltschranksystem 1 weist ein Basismodul 2 und zumindest ein Funktionsmodul 60 auf. Das allgemein beschriebene Funktionsmodul 60 kann als beispielsweise als ein erstes Funktionsmodul 3, ein zweites Funktionsmodul 4, ein drittes Funktionsmodul 5, ein viertes Funktionsmodul 6, ein fünftes Funktionsmodul 7 oder ein sechstes Funktionsmodul 8 ausgebildet sein. Aber auch jede weitere Ausbildung des Funktionsmoduls 60 ist denkbar. Sofern die im Folgenden beschriebenen Merkmale sowohl für das erste Funktionsmodul 3, das zweite Funktionsmodul 4, das dritte Funktionsmodul 5, das vierte Funktionsmodul 6, das fünfte Funktionsmodul 7 und das sechste Funktionsmodul 8 zutreffen, wird allgemein nur von dem Funktionsmodul 60, bzw. den Funktionsmodulen 60 gesprochen.

Beispielhaft weist das Schaltschranksystem 1 der Fig. 1 ein erstes Funktionsmodul 3, zwei zweite Funktionsmodule 4, fünf dritte Funktionsmodule 5, zehn vierte Funktionsmodule 6, zehn fünfte Funktionsmodule 7 und fünfzehn sechste Funktionsmodule 8 auf. Das Schaltschranksystem 1 kann jedoch auch beliebig viele erste Funktionsmodule 3, zweite Funktionsmodule 4, dritte Funktionsmodule 5, vierte Funktionsmodule 6, fünfte Funktionsmodule 7, sechste Funktionsmodule 8 und/oder auch andere Funktionsmodule aufweisen.

Das Basismodul 2 weist ein Basisgehäuse 9 mit einer Oberseite 10 auf. Die Funktionsmodule 60 weisen jeweils ein Funktionsgehäuse 11 mit einer Unterseite 12 auf. Die Funktionsmodule 60 liegen mit ihren Unterseiten 12 jeweils an der Oberseite 10 des Basisgehäuses 9 an. Aus diesem Grund sind die Unterseiten 12 der Funktionsmodule 60 in Fig. 1 nicht zu erkennen.

Bis auf die sechsten Funktionsmodule 8 können die übrigen ersten Funktionsmodule 3, zweiten Funktionsmodule 4, dritten Funktionsmodule 5, vierten Funktionsmodule 6 und/oder fünften Funktionsmodule 7 jeweils Peripherieanschlusselemente 13 aufweisen, wie entsprechend in Fig. 1 dargestellt. Eine Anzahl, eine Ausgestaltung und Positionen der Peripherieanschlusselemente 13 können für alle ersten bis fünften Funktionsmodule 3, 4, 5, 6, 7 von der beispielhaften Darstellung der Fig. 1 abweichen. Durch die Peripherieanschlüsse 13 können Feldgeräte an das Schaltschranksystem 1 angeschlossen werden. Bei Feldgeräten kann es sich beispielsweise um Aktoren und/oder Sensoren handeln. Die Feldgeräte können beispielsweise Teil einer Produktionsmaschine sein, die vom Schaltschranksystem 1 gesteuert werden kann. Die Feldgeräte können über die Peripherieanschlüsse 13 Daten, Signale oder Versorgungsspannungen mit den Funktionsmodulen 60 austauschen.Das Basismodul 2 des Schaltschranksystems 1 kann beispielsweise anwendungsspezifische integrierte Schaltungen aufweisen, die in Verbindung mit den ersten bis fünften Funktionsmodule 3, 4, 5, 6, 7 als Slaves oder Master fungieren, um die Feldgeräte nach dem Master-Slave Prinzipautomatisiert ansteuern zu können. Dabei können die Daten zwischen den ersten bis fünften Funktionsmodulen 3, 4, 5, 6, 7 über das Basismodul 2 beispielsweise über ein EtherCAT-Protokoll gemäß dem Standard IEC 61158 ausgetauscht werden.Ferner kann das Schaltschranksystem 1 als Verteilersystem für elektrische Spannungen fungieren, die den Feldgeräten für einen Betrieb bereitgestellt werden können.

Das erste Funktionsmodul 3 weist beispielhaft ein Regelelement 14 auf. Das erste Funktionsmodul 3 kann als übergeordnetes Funktionsmodul aufgefasst werden. Beispielsweise kann es sein, dass Daten und Spannungen in das erste Funktionsmodul 3 eingespeist und an die übrigen zweiten bis sechsten Funktionsmodule 4, 5, 6, 7, 8 weitergeleitet werden.

Das Basismodul 2 weist beispielhaft einen ersten Kanal 17, einen zweiten Kanal 18 und einen dritten Kanal 19 auf. Das Basismodul 2 kann jedoch auch nur den ersten Kanal 17 oder nur den ersten Kanal 17 und den zweiten Kanal 18 oder auch mehr als die drei ersten bis dritten Kanäle 17, 18, 19 aufweisen. Die Funktionsgehäuse 11 der vierten Funktionsmodule 6, der fünften Funktionsmodule 7 und der sechsten Funktionsmodule 8 erstrecken sich beispielhaft jeweils lediglich über den ersten Kanal 17, den zweiten Kanal 18 oder den dritten Kanal 19 des Basismoduls 2. Die zweiten Funktionsmodule 4 und die dritten Funktionsmodule 5 erstrecken sich beispielhaft jeweils über den zweiten Kanal 18 und den dritten Kanal 19. Das erste Funktionsmodul 3 erstreckt sich beispielhaft über alle drei ersten bis dritten Kanäle 17, 18, 19.

Das Basismodul 2 weist beispielhaft insgesamt vierundzwanzig Steckplätze 20 pro ersten bis dritten Kanal 17, 18, 19 auf. Das Basismodul 2 kann jedoch eine beliebige Anzahl von Steckplätzen 20 pro ersten bis dritten Kanal 17, 18, 19 aufweisen. Die vierten Funktionsmodule 6, die fünften Funktionsmodule 7 und die sechsten Funktionsmodule 8 erstrecken sich jeweils über einen Steckplatz 20. Die zweiten Funktionsmodule 4 und die dritten Funktionsmodule 5 erstrecken sich jeweils über vier Steckplätze 20. Das erste Funktionsmodul 3 erstreckt sich über neun Steckplätze 20.

Das Schaltschranksystem 1 weist erste und zweite Kabelführungselemente 15, 16 auf. Die ersten Kabelführungselemente 15 sind auf der Oberseite 10 des Basismoduls 2 zwischen den Funktionsmodulen 60 angeordnet und erstrecken sich in eine Richtung senkrecht zur Oberseite 10 des Basisgehäuses 9. Die zweiten Kabelführungselemente 16 sind seitlich am Basisgehäuse 9 angeordnet und erstrecken sich in eine Richtung parallel zur Oberseite 10 des Basisgehäuses 9. Eine Anzahl der ersten und zweiten Kabelführungselemente 15, 16 kann beliebig sein. Auch eine Anordnung der ersten und zweiten Kabelführungselemente 15, 16 kann von der in Fig. 1 gezeigten Anordnung abweichen. Die ersten und/oder zweiten Kabelführungselemente 15, 16 können auch entfallen.

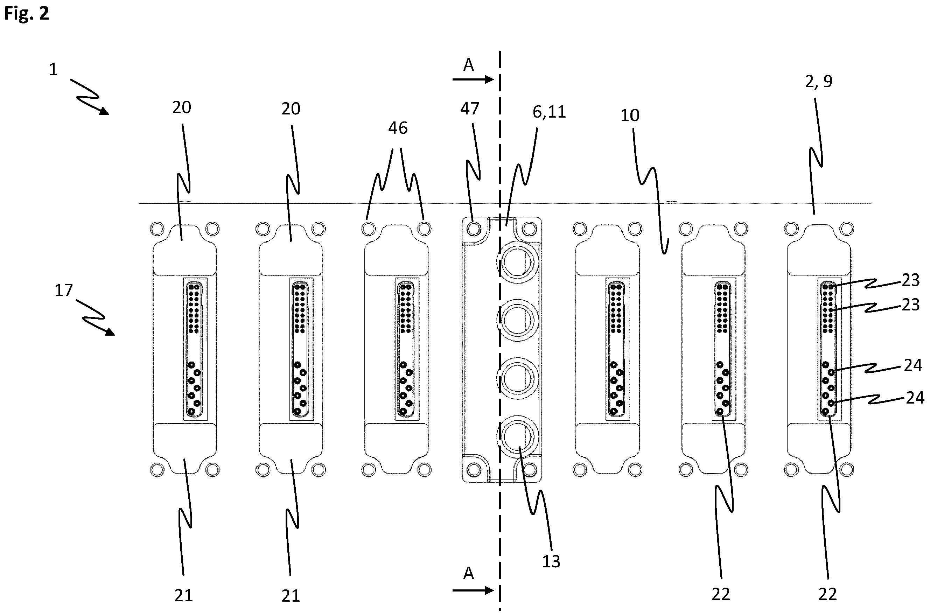

Fig. 2 zeigt schematisch eine Draufsicht auf einen Ausschnitt des Schaltschranksystems 1 der Fig. 1. Der Ausschnitt zeigt lediglich einen Teil des ersten Kanals 17 des Basismoduls 2 und beispielhaft ein viertes Funktionsmodul 6, das im Bereich des ersten Kanals 17 auf der Oberseite 10 des Basisgehäuses 9 angeordnet ist. Zu dem in Fig. 2 gezeigten vierten Funktionsmodul 6 benachbarte Funktionsmodule sind in Fig. 2 der Übersicht halber nicht dargestellt.

Das Basisgehäuse 9 weist an seiner Oberseite 10 zweite Durchgangsöffnung 21 auf. Pro Steckplatz 20 ist eine zweite Durchgangsöffnung 21 vorgesehen. Basisanschlusselemente 22 des Basismoduls 2 sind im Basisgehäuse 9 und jeweils im Bereich der zweiten Durchgangsöffnungen 21 angeordnet. Die Basisanschlusselemente 22 können entweder als Einbaustecker oder als Einbaubuchsen ausgebildet sein. Beispielhaft sind die Basisanschlusselemente 22 der Fig. 2 als Einbaubuchsen ausgebildet.

Die Basisanschlusselemente 22 weisen beispielhaft achtzehn erste Kontaktöffnungen 23 und sieben zweite Kontaktöffnungen 24 auf. Die Basisanschlusselemente 22 können jedoch auch eine andere Anzahl von ersten und zweiten Kontaktöffnungen 23, 24 aufweisen. Positionen der ersten und zweiten Kontaktöffnungen 23, 24 können von den in Fig. 2 gezeigten Positionen abweichen.

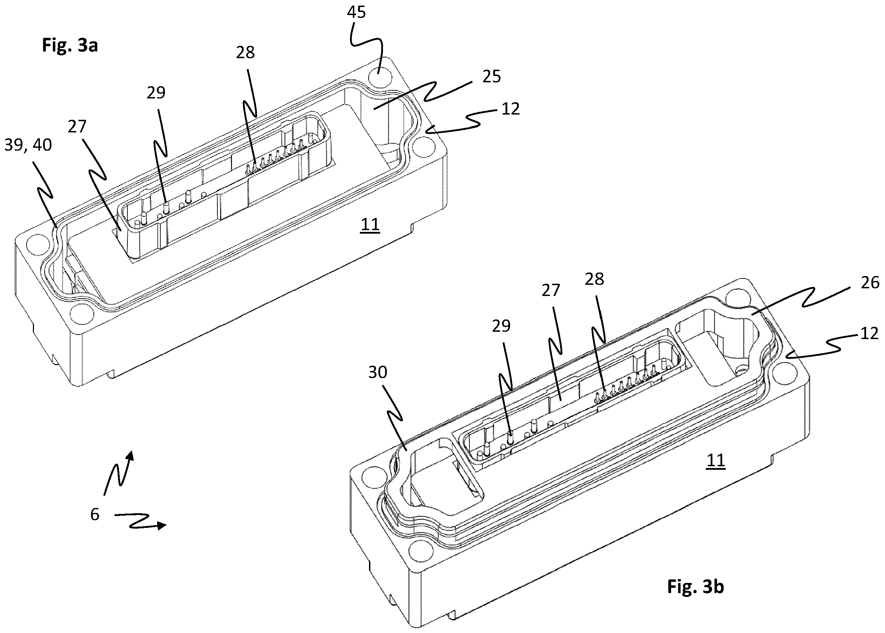

Die Fig. 3a und 3b zeigen schematisch verschiedene perspektivische Ansichten auf die Unterseite 12 des Funktionsgehäuses 11 des vierten Funktionsmoduls 6 des Schaltschranksystems 1. Fig. 3a zeigt das vierte Funktionsmodul 6 ohne einen Dichtungseinsatz 26, während Fig. 3b das vierte Funktionsmodul 6 mit einem Dichtungseinsatz 26zeigt.

Das Funktionsgehäuse 11 weist an seiner Unterseite 12 eine erste Durchgangsöffnung 25 auf. Ein Querschnitt der ersten Durchgangsöffnung 25 des Funktionsgehäuses 11 kann mit einem Querschnitt einer zweiten Durchgangsöffnung 21 des Basisgehäuses 9 identisch sein, was jedoch nicht zwingend erforderlich ist. Im Schaltschranksystem 1, wenn das Funktionsgehäuse 11 mit der Unterseite 12 an der Oberseite 10 des Basisgehäuses 9 anliegt, liegen die erste Durchgangsöffnung 25 und die zweite Durchgangsöffnung 21 übereinander.

Im Funktionsgehäuse 11 und im Bereich der ersten Durchgangsöffnung 25 ist ein Funktionsanschlusselement 27 angeordnet. Das Funktionsanschlusselement 27 kann entweder als Einbaustecker oder als Einbaubuchse ausgebildet sein. Beispielhaft ist Funktionsanschlusselement 27 als Einbaustecker ausgebildet.

Das Funktionsanschlusselement 27 weist entsprechend der Anzahl der ersten und zweiten Kontaktöffnungen 23, 24 der Basisanschlusselemente 22 achtzehn erste Kontaktstifte 28 und sieben zweite Kontaktstifte 29 auf. Im Schaltschranksystem 1 greifen ein Basisanschlusselement 22 und das Funktionsanschlusselement 27 ineinander und bilden eine Schnittstelle. Über die Schnittstelle können Daten zwischen dem Basismodul 2 und dem vierten Funktionsmodul 6 ausgetauscht werden. Auch elektrische Spannungen können dem vierten Funktionsmodul 6 vom Basismodul 2 bereitgestellt werden.

Der Dichtungseinsatz 26 des vierten Funktionsmoduls 6 weist einen Rahmen 30 auf, der in das Funktionsgehäuse 11 eingreift. Das Funktionsanschlusselement 27 kann derart angeordnet sein, dass es nicht weiter aus dem Funktionsgehäuse 11 herausragt als der Rahmen 30 des Dichtungseinsatzes 26. Dadurch ist das Funktionsanschlusselement 27 auch dann gegen mechanische Belastungen geschützt, wenn das vierte Funktionsmodul 6 aus dem Schaltschranksystem 1 ausgebaut wird.

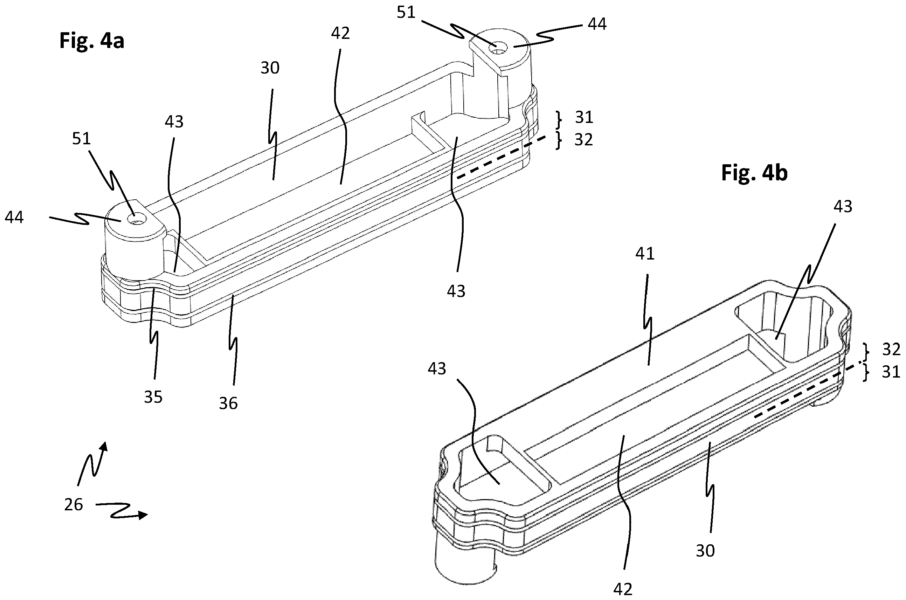

Die Fig. 4a und 4b zeigen schematisch den Dichtungseinsatz 26 des vierten Funktionsmoduls 6 in verschiedenen perspektivischen Ansichten.

Der Rahmen 30 des Dichtungseinsatzes 26 weist einen Funktionsabschnitt 31 und einen Basisabschnitt 32 auf. Der Funktionsabschnitt 31 greift in das Funktionsgehäuse 11 ein, weshalb der Funktionsabschnitt 31 in den Fig. 3a und 3b nicht zu erkennen ist. Der Basisabschnitt 32 des Rahmens 30 greift in das Basisgehäuse 9 ein. Der Basisabschnitt 32 des Rahmens ist außerhalb des Funktionsgehäuses 11 angeordneten angeordnet.

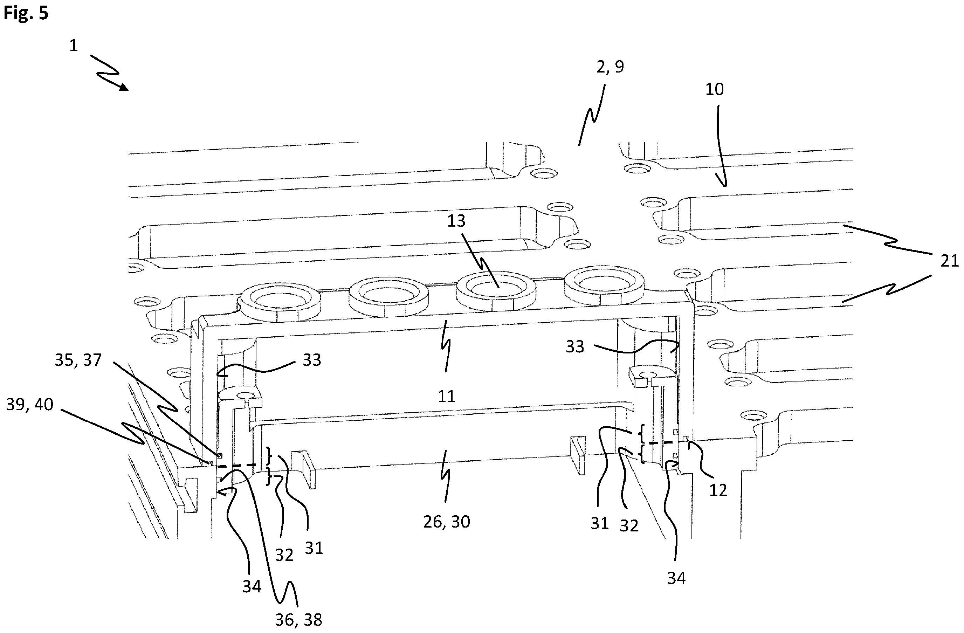

Fig. 5 zeigt schematisch eine perspektivische Querschnittsansicht A-A auf eine in Fig. 2 mittels einer gestrichelten Linie angedeuteten Ebene, die durch das Schaltschranksystem 1 verläuft. Die Basisanschlusselemente 22 und das Funktionsanschlusselement 27 sind in Fig. 5 der Übersicht halber nicht gezeigt.

Der Funktionsabschnitt 31 des Rahmens 30 liegt an einer Innenwandung 33 des Funktionsgehäuses 11 an. Der Basisabschnitt 32 des Rahmens 30 liegt an einer die zweite Durchgangsöffnung 21 umgrenzenden Wandung 34 des Basisgehäuses 9 an. Vorteilhafterweise kann das Schaltschranksystem 1 durch den Dichtungseinsatz 26 beispielsweise gegen das Eindringen von Feuchtigkeit und/oder Staubpartikeln geschützt sein. Da der Funktionsabschnitt 31 des Dichtungseinsatzes 26 an der Innenwandung 33 des Funktionsgehäuses 11 anliegt und der Basisabschnitt 32 des Dichtungseinsatzes 26 an der die zweite Durchgangsöffnung 21 umgrenzenden Wandung 34 des Basisgehäuses 9 anliegt, kann verhindert werden, dass zwischen der Unterseite 12 des Funktionsgehäuses 11 und der Oberseite 10 des Basisgehäuses 9 eindringende Feuchtigkeit und/oder Partikel in das Schaltschranksystem 1 gelangen.

Der Rahmen 30 des Dichtungseinsatzes 26 weist eine erste Nut 35 und eine zweite Nut 36 auf. Die erste Nut 35 ist um den Funktionsabschnitt 31 des Rahmens 30 umlaufend und die zweite Nut 36 um den Basisabschnitt 32 des Rahmens 30 umlaufend ausgebildet, was auch in den Fig. 4a und 4b zu erkennen ist. Eine erste Dichtung 37 ist in der ersten Nut 35 angeordnet. Die erste Dichtung 37 liegt an der Innenwandung 33 des Funktionsgehäuses 11 an. Die erste Dichtung 37 kann beispielsweise eine angespritzte Dichtung sein. Eine zweite Dichtung 38 ist in der zweiten Nut 36 angeordnet und liegt an der die zweite Durchgangsöffnung 21 umgebenden Wandung 34 des Basisgehäuses 9 an. Auch die zweite Dichtung 38 kann beispielsweise angespritzt sein.

Die Unterseite 12 des Funktionsgehäuses 11 weist eine die erste Durchgangsöffnung 25 umgrenzende dritte Nut 39 auf. Eine dritte Dichtung 40 ist in der dritten Nut 39 angeordnet und liegt an der Oberseite 10 des Basisgehäuses 9 an. Bei der dritten Dichtung 40 kann es sich beispielsweise um einen O-Ring handeln.

Vorteilhafterweise kann das Schaltschranksystem 1 durch die erste Dichtung 37, die zweite Dichtung 38 und die dritte Dichtung 40 die Schutzart IP69k bzw. IP67 erfüllen. Die erste Dichtung 37 und die zweite Dichtung 38 können jedoch auch entfallen. Auch die dritte Dichtung 40 kann entfallen. Ist eine der ersten, zweiten und/oder dritten Dichtungen 37, 38, 40 nicht vorgesehen, so entfällt auch die entsprechende erste, zweite und/oder dritte Nut 35, 36, 39, in der die jeweilige erste, zweite und/oder dritte Dichtung 37, 38, 40 angeordnet ist.

Im Folgenden werden weitere optionale Merkmale des Dichtungseinsatzes 26 des Schaltschranksystems 1 mit Bezugnahme auf die Fig. 4a und 4b und Fig. 5 erläutert.

Der Dichtungseinsatz 26 weist eine starr mit dem Rahmen 30 verbundene Abdeckung 41 auf. Die Abdeckung 41 ist innerhalb eines vom Rahmen 30 umgrenzten Bereichs angeordnet. Beispielhaft ist die Abdeckung 41 im Bereich des Basisabschnitts 32 angeordnet. Die Abdeckung 41 weist eine Aussparung 42 auf. Das Funktionsanschlusselement 27 ist im Bereich der Aussparung 42 angeordnet. Im Schaltschranksystem 1 ist die Schnittstelle im Bereich der Aussparung 42 angeordnet, d.h. das Funktionsanschlusselement 27 und das in das Funktionsanschlusselement 27 eingreifende Basisanschlusselement 22 sind im Bereich der Aussparung 42 angeordnet.

Die Abdeckung 41 weist beispielhaft zwei weitere Aussparungen 43 auf. Der Dichtungseinsatz 26 kann jedoch auch eine beliebige Anzahl von weiteren Aussparungen 43 aufweisen. Die weiteren Aussparungen 43 der Abdeckung 41 bieten den Vorteil, dass Kühlluft zwischen dem Basismodul 2 und dem vierten Funktionsmodul 6 ausgetauscht werden kann, sodass im Funktionsgehäuse 22 des vierten Funktionsmoduls 6 angeordnete Komponenten, wie beispielsweise eine Platine, gekühlt werden können.

Der Dichtungseinsatz 26 weist beispielhaft zwei mit dem Rahmen 30 starr verbundene Halteabschnitte 44 auf. Die Halteabschnitte 44 sind beispielhaft an sich gegenüberliegenden Seiten des Dichtungseinsatzes 26 angeordnet. Der Dichtungseinsatz 26 kann jedoch auch eine beliebige Anzahl von Halteabschnitten 44 aufweisen. Die Halteabschnitte 44 erstrecken sich in eine Richtung senkrecht zum Rahmen 30 und ragen in das Funktionsgehäuse 11 hinein. Die Halteabschnitte 44 sind durch die weiteren Aussparungen 43 zugänglich. Die weiteren Aussparungen 43 ermöglichen es, den Dichtungseinsatz 26 mittels eines Werkzeugs am Funktionsgehäuse 11 zu fixieren.

Der Dichtungseinsatz 26 ist an den Halteabschnitten 44 am Funktionsgehäuse 11 fixiert. Der Dichtungseinsatz 26 kann beispielsweise mittels Schrauben am Funktionsgehäuse 11 fixiert sein. Dazu weisen die Halteabschnitte 44 jeweils eine Öffnung 51 auf. Die Innenwandung 33 des Funktionsgehäuses 11 kann beispielsweise Sacklöcher zum Befestigen des Dichtungseinsatzes 26 aufweisen.

Die weiteren Aussparungen 43 können auch entfallen. In diesem Fall können auch die Halteabschnitte 44 des Dichtungseinsatzes 26 entfallen. Alternativ kann aber auch die Abdeckung 41 entfallen. Dann wären optionale Halteabschnitte 44 ebenfalls mit einem Werkzeug zugänglich.

Im Folgenden werden weitere optionale Merkmale des Schaltschranksystems 1 mit Bezugnahme auf die Fig. 1, 2 und 3a erläutert.

Die Funktionsgehäuse 11 der Funktionsmodule 60 weisen jeweils eine Mehrzahl von senkrecht zu ihren Unterseite 12 ausgebildeten Schraubenkanälen 45 auf. Die Schraubenkanäle 45 sind jeweils um die erste Durchgangsöffnung 25 der Funktionsgehäuse 11 herum angeordnet. Das Basisgehäuse 9 weist an seiner Oberseite 10 eine Mehrzahl von Sacklöchern 46 auf. Die Sacklöcher 46 sind um zweite Durchgangsöffnungen 21 herum angeordnet. Schrauben 47 erstrecken sich jeweils durch die Schraubenkanäle 45 und sind in den Sacklöchern 46 verschraubt.

Eine in Bezug auf die Unterseiten 12 der Funktionsgehäuse 11 bemessene Höhe 48 der Schraubenkanäle 45 kann beispielsweise mindestens der Hälfte einer Differenz zwischen einem maximalen lateralen Abstand der Schraubenkanäle 45 untereinander und einem Schraubenkopfdurchmesser der verwendeten Schrauben 47 entsprechen. Dies kann gewährleisten, dass durch die Schrauben 47 ein gleichmäßiger Druck auf eine dritte Dichtung 40 ausgeübt wird, da sich die Druckkegel zweier benachbarter Schrauben 47 in der Dichtfläche der dritten Dichtung 40 schneiden. Ist die Höhe 48 der Schraubenkanäle 45 hingegen kleiner als die Hälfte der Differenz zwischen dem maximalen lateralen Abstand der Schraubenkanäle 45 untereinander und dem Schraubenkopfdurchmesser der verwendeten Schrauben 47, so kann es sein, dass eine dritte Dichtung 40 abschnittsweise außerhalb von Druckkegeln der Schrauben 47 angeordnet ist. Je nach Anwendungsfall kann jedoch auch eine derartige Druckwirkung auf eine dritte Dichtung 40 ausreichend sein, um eine gewünschte Dichtwirkung zu erzielen.

Die Schraubenkanäle 45, die Sacklöcher 46 und die Schrauben 47 können jedoch auch entfallen. Es kann alternativ auch ein anderer Mechanismus vorgesehen sein, um die Funktionsmodule 60 am Basismodul 2 zu befestigen. Beispielsweise können Klammern am Basismodul 2 vorgesehen sein, in die die Funktionsmodule 60 einrasten können.

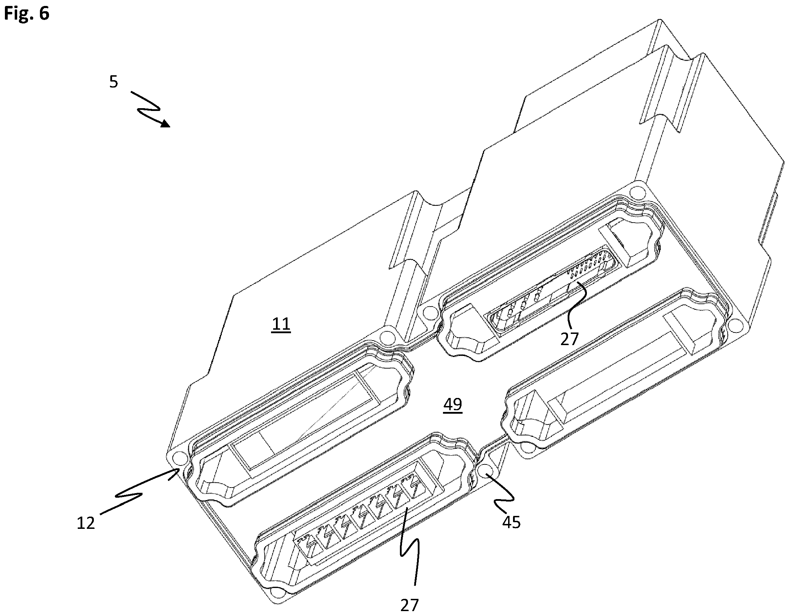

Fig. 6 zeigt schematisch das dritte Funktionsmodul 5 in einer perspektivischen Ansicht auf die Unterseite 12.

Im Gegensatz zum vierten Funktionsmodul 6, das lediglich einen Steckplatz 20 auf dem Basismodul 2 belegt, belegt das dritte Funktionsmodul 5 vier Steckplätze 20 und erstreckt sich dabei über die zweiten und dritten Kanäle 18, 19. Grundsätzlich kann sich ein Funktionsmodul 60 über eine beliebige Anzahl von Steckplätzen 20 und ersten bis dritten Kanälen 17, 18, 19 erstrecken. Beispielhaft weist das dritte Funktionsmodul 5 der Fig. 6 jedoch lediglich zwei Funktionsanschlusselemente 27 auf. Die beiden Funktionsanschlusselemente 27 des dritten Funktionsmoduls 5 müssen sich nicht, wie in Fig. 6 beispielhaft dargestellt, diagonal gegenüberliegen. Beispielhaft deutet Fig. 6 an, dass die Funktionsanschlusselemente 27 des dritten Funktionsmoduls 5 unterschiedlich ausgebildet sind, was ebenfalls nicht erforderlich ist. Das dritte Funktionsmodul 5 kann auch nur ein, drei oder vier Funktionsanschlusselemente 27 aufweisen, die identisch oder unterschiedlich ausgebildet sein können.

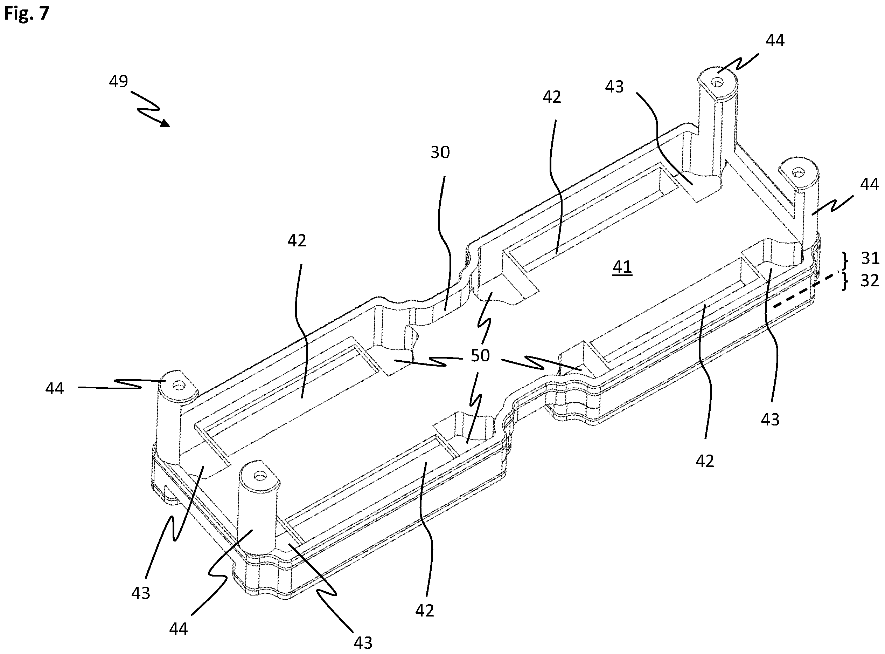

Das dritte Funktionsmodul 5 weist einen weiteren Dichtungseinsatz 49 auf. Fig. 7 zeigt schematisch den weiteren Dichtungseinsatz 49 für das dritte Funktionsmodul 5 in einer perspektivischen Ansicht. Der weitere Dichtungseinsatz 49 weist Ähnlichkeiten im Vergleich zum Dichtungseinsatz 26 auf. Die Bezugszeichen für den Dichtungseinsatz 26 werden für den weiteren Dichtungseinsatz beibehalten.

Der weitere Dichtungseinsatz 49 weist einen Rahmen 30 auf. Der Rahmen 30 weist einen Funktionsabschnitt 31 und einen Basisabschnitt 32 auf. Der Funktionsabschnitt 31 des weiteren Dichtungseinsatzes 49 ist dazu ausgebildet, in das Funktionsgehäuse 11 des dritten Funktionsmoduls 5 einzugreifen, während der Basisabschnitt 32 dazu ausgebildet ist, in das Basisgehäuse 9 einzugreifen. Der weitere Dichtungseinsatz 49 weist eine Abdeckung 41 auf. Die Abdeckung 41 ist innerhalb eines vom Rahmen 30 umgrenzten Bereichs angeordnet. Beispielhaft ist die Abdeckung 41 im Bereich des Basisabschnitts 32 angeordnet. Die Abdeckung 41 kann auch entfallen. Im Vergleich zum Dichtungseinsatz 26 weist der weitere Dichtungseinsatz 49 vier optionale Aussparungen 42, vier optionale weitere Aussparungen 43, vier optionale Halteabschnitte 44 und vier optionale zusätzliche Aussparungen 50 auf.

## Patentansprüche

1. Schaltschranksystem (1)
mit einem Basismodul (2) und zumindest einem Funktionsmodul (60),
wobei das Funktionsmodul (60) ein Funktionsgehäuse (11) aufweist,
wobei das Funktionsgehäuse (11) an einer Unterseite (12) eine erste Durchgangsöffnung (25) aufweist,
wobei ein Funktionsanschlusselement (27) des Funktionsmoduls (60) im Funktionsgehäuse (11) und im Bereich der ersten Durchgangsöffnung (25) angeordnet ist,
wobei das Basismodul (2) ein Basisgehäuse (9) aufweist,
wobei das Basisgehäuse (9) an einer Oberseite (10) eine zweite Durchgangsöffnung (21) aufweist,
wobei ein Basisanschlusselement (22) des Basismoduls (2) im Basisgehäuse (9) und im Bereich der zweiten Durchgangsöffnung (21) angeordnet ist,
wobei das Funktionsgehäuse (11) mit der Unterseite (12) an der Oberseite (10) des Basisgehäuses (9) anliegt,
wobei das Funktionsanschlusselement (27) und das Basisanschlusselement (22) ineinander greifen und eine Schnittstelle bilden,
**dadurch gekennzeichnet, dass** das Schaltschranksystem (1) einen Dichtungseinsatz (26, 49) mit einem Rahmen (30) aufweist,
wobei der Rahmen des Dichtungseinsatzes (26, 49) einen in das Funktionsgehäuse (11) eingreifenden Funktionsabschnitt (31) und einen in das Basisgehäuse (9) eingreifenden Basisabschnitt (32) aufweist,
wobei der Funktionsabschnitt (31) des Rahmens (30) an einer Innenwandung (33) des Funktionsgehäuses (11) anliegt,
wobei der Basisabschnitt (32) des Rahmens (30) an einer die zweite Durchgangsöffnung (21) umgrenzenden Wandung (34) des Basisgehäuses (9) anliegt,
wobei der Rahmen (30) des Dichtungseinsatzes (26, 49) eine erste Nut (35) und eine zweite Nut (36) aufweist,
wobei die erste Nut (35) um den Funktionsabschnitt (31) des Rahmens (30) umlaufend und die zweite Nut (36) um den Basisabschnitt (32) des Rahmens (30) umlaufend ausgebildet ist,
wobei eine erste Dichtung (37) in der ersten Nut (35) angeordnet ist und an der Innenwandung (33) des Funktionsgehäuses (11) anliegt,
wobei eine zweite Dichtung (38) in der zweiten Nut (36) angeordnet ist und an der die zweite Durchgangsöffnung (21) umgebenden Wandung (34) des Basisgehäuses (9) anliegt,
wobei die Unterseite (12) des Funktionsgehäuses (11) eine die erste Durchgangsöffnung (21) umgrenzende dritte Nut (39) aufweist,
wobei eine dritte Dichtung (40) in der dritten Nut (39) angeordnet und an der Oberseite (10) des Basisgehäuses (9) anliegt.

2. Schaltschranksystem (1) gemäß Anspruch 1,
wobei der Dichtungseinsatz (26, 49) eine starr mit dem Rahmen (30) verbundene Abdeckung (41) aufweist,
wobei die Abdeckung (41) innerhalb eines vom Rahmen (30) umgrenzten Bereichs angeordnet ist,
wobei die Abdeckung (41) eine Aussparung (42) aufweist,
wobei die Schnittstelle im Bereich der Aussparung (42) angeordnet ist.

3. Schaltschranksystem (1) gemäß Anspruch 2,
wobei die Abdeckung (41) zumindest eine weitere Aussparung (43) aufweist.

4. Schaltschranksystem (1) gemäß Anspruch 3,
wobei der Dichtungseinsatz (26, 49) zumindest zwei mit dem Rahmen (30) starr verbundene Halteabschnitte (44) aufweist,
wobei die Halteabschnitte (44) sich in eine Richtung senkrecht zum Rahmen (30) erstrecken und in das Funktionsgehäuse (11) hineinragen,
wobei die Halteabschnitte (44) durch die weiteren Aussparungen (43) zugänglich sind,
wobei der Dichtungseinsatz (26, 49) an den Halteabschnitten (44) am Funktionsgehäuse (11) fixiert ist.

5. Schaltschranksystem (1) gemäß einem der Ansprüche 1 bis 4,
wobei das Funktionsanschlusselement (27) nicht weiter aus dem Funktionsgehäuse (11) heraus ragt als der Rahmen (30) des Dichtungseinsatzes (26, 49).

6. Funktionsmodul (60) ausgestaltet für ein Schaltschranksystem (1) nach Anspruch 1
wobei das Funktionsmodul (60) ein Funktionsgehäuse (11) aufweist,
wobei das Funktionsgehäuse (11) an einer Unterseite (12) eine erste Durchgangsöffnung (25) aufweist,
wobei ein Funktionsanschlusselement (27) des Funktionsmoduls (60) im Funktionsgehäuse (11) und im Bereich der ersten Durchgangsöffnung (25) angeordnet ist, **dadurch gekennzeichnet, dass** das Funktionsmodul (60) einen Dichtungseinsatz (26, 49) mit einem Rahmen (30) aufweist,
wobei der Rahmen (30) des Dichtungseinsatzes (26, 49) einen in das Funktionsgehäuse (11) eingreifenden Funktionsabschnitt (31) und einen außerhalb des Funktionsgehäuses (11) angeordneten Basisabschnitt (32) aufweist,
wobei der Funktionsabschnitt (31) des Rahmens (30) an einer Innenwandung (33) des Funktionsgehäuses (11) anliegt,
wobei der Rahmen (30) des Dichtungseinsatzes (26, 49) eine erste Nut (35) und eine zweite Nut (36) aufweist,
wobei die erste Nut (35) um den Funktionsabschnitt (31) des Dichtungseinsatzes (26, 49) umlaufend und die zweite Nut (36) um den Basisabschnitt (32) des Dichtungseinsatzes (26, 49) umlaufend ausgebildet ist,
wobei eine erste Dichtung (37) in der ersten Nut (35) angeordnet ist und an der Innenwandung (33) des Funktionsgehäuses (11) anliegt,
wobei eine zweite Dichtung (38) in der zweiten Nut (36) angeordnet ist,
wobei die Unterseite (12) des Funktionsgehäuses (11) eine die erste Durchgangsöffnung (25) umgrenzende dritte Nut (39) aufweist,
wobei eine dritte Dichtung (40) in der dritten Nut (39) angeordnet ist.

7. Funktionsmodul (60) gemäß Anspruch 6,
wobei der Dichtungseinsatz (26, 49) eine starr mit dem Rahmen (30) verbundene Abdeckung (41) aufweist,
wobei die Abdeckung (41) innerhalb eines vom Rahmen (30) umgrenzten Bereichs angeordnet ist,
wobei die Abdeckung (41) eine Aussparung (42) aufweist,
wobei das Funktionsanschlusselement (27) im Bereich der Aussparung (42) angeordnet ist.

8. Funktionsmodul (60) gemäß Anspruch 7,
wobei die Abdeckung (41) zumindest eine weitere Aussparung (43) aufweist.

9. Funktionsmodul (60) gemäß Anspruch 8,
wobei der Dichtungseinsatz (26, 49) zumindest zwei mit dem Rahmen (30) starr verbundene Halteabschnitte (44) aufweist,
wobei die Halteabschnitte (44) sich in eine Richtung senkrecht zum Rahmen (30) erstrecken und in das Funktionsgehäuse (11) hineinragen,
wobei die Halteabschnitte (44) durch die weiteren Aussparungen (43) zugänglich sind,
wobei der Dichtungseinsatz (26, 49) an den Halteabschnitten (44) am Funktionsgehäuse (11) fixiert ist.

10. Funktionsmodul (60) gemäß einem der Ansprüche 6 bis 9,
wobei das Funktionsanschlusselement (27) nicht weiter aus dem Funktionsgehäuse (11) heraus ragt als der Rahmen (30) des Dichtungseinsatzes (26, 49).

11. Dichtungseinsatz (26, 49) ausgestaltet für ein Schaltschranksystem (1) gemäß einem der Ansprüche 1 bis 5 und ein Funktionsmodul (60) gemäß einem der Ansprüche 6 bis 10.

## Claims

1. Switchgear cabinet system (1)
having a base module (2) and at least one functional module (60),
wherein the functional module (60) has a functional housing (11),
wherein the functional housing (11) has a first passage opening (25) on a bottom side (12),
wherein a functional connection element (27) of the functional module (60) is arranged in the functional housing (11) and in the region of the first passage opening (25),
wherein the base module (2) has a base housing (9), wherein the base housing (9) has a second passage opening (21) on a top side (10),
wherein a base connection element (22) of the base module (2) is arranged in the base housing (9) and in the region of the second passage opening (21),
wherein the functional housing (11) bears against the top side (10) of the base housing (9) by way of the bottom side (12),
wherein the functional connection element (27) and the base connection element (22) interengage and form an interface,
**characterized in that** the switchgear cabinet system (1) has a sealing insert (26, 49) with a frame (30),
wherein the frame of the sealing insert (26, 49) has a functional portion (31) engaging into the functional housing (11) and a base portion (32) engaging into the base housing (9),
wherein the functional portion (31) of the frame (30) bears against an inner wall (33) of the functional housing (11),
wherein the base portion (32) of the frame (30) bears against a wall (34) of the base housing (9) bordering the second passage opening (21),
wherein the frame (30) of the sealing insert (26, 49) has a first groove (35) and a second groove (36),
wherein the first groove (35) is designed so as to run around the functional portion (31) of the frame (30) and the second groove (36) is designed so as to run around the base portion (32) of the frame (30),
wherein a first seal (37) is arranged in the first groove (35) and bears against the inner wall (33) of the functional housing (11),
wherein a second seal (38) is arranged in the second groove (36) and bears against the wall (34) of the base housing (9) that surrounds the second passage opening (21),
wherein the bottom side (12) of the functional housing (11) has a third groove (39) bordering the first passage opening (21),
wherein a third seal (40) is arranged in the third groove (39) and bears against the top side (10) of the base housing (9).

2. Switchgear cabinet system (1) according to Claim 1, wherein the sealing insert (26, 49) has a cover (41) rigidly connected to the frame (30),
wherein the cover (41) is arranged within a region bordered by the frame (30),
wherein the cover (41) has a cutout (42),
wherein the interface is arranged in the region of the cutout (42).

3. Switchgear cabinet system (1) according to Claim 2, wherein the cover (41) has at least one further cutout (43) .

4. Switchgear cabinet system (1) according to Claim 3, wherein the sealing insert (26, 49) has at least two retaining portions (44) rigidly connected to the frame (30),
wherein the retaining portions (44) extend in a direction perpendicular to the frame (30) and project into the functional housing (11),
wherein the retaining portions (44) are accessible through the further cutouts (43),
wherein the sealing insert (26, 49) is fixed to the retaining portions (44) on the functional housing (11).

5. Switchgear cabinet system (1) according to one of Claims 1 to 4, wherein the functional connection element (27) does not project further out of the functional housing (11) than the frame (30) of the sealing insert (26, 49).

6. Functional module (60) configured for a switchgear cabinet system (1) according to Claim 1,
wherein the functional module (60) has a functional housing (11),
wherein the functional housing (11) has a first passage opening (25) on a bottom side (12),
wherein a functional connection element (27) of the functional module (60) is arranged in the functional housing (11) and in the region of the first passage opening (25),
**characterized in that** the functional module (60) has a sealing insert (26, 49) with a frame (30),
wherein the frame (30) of the sealing insert (26, 49) has a functional portion (31) engaging into the functional housing (11) and a base portion (32) arranged outside the functional housing (11),
wherein the functional portion (31) of the frame (30) bears against an inner wall (33) of the functional housing (11),
wherein the frame (30) of the sealing insert (26, 49) has a first groove (35) and a second groove (36),
wherein the first groove (35) is designed so as to run around the functional portion (31) of the sealing insert (26, 49) and the second groove (36) is designed so as to run around the base portion (32) of the sealing insert (26, 49),
wherein a first seal (37) is arranged in the first groove (35) and bears against the inner wall (33) of the functional housing (11),
wherein a second seal (38) is arranged in the second groove (36),
wherein the bottom side (12) of the functional housing (11) has a third groove (39) bordering the first passage opening (25),
wherein a third seal (40) is arranged in the third groove (39) .

7. Functional module (60) according to Claim 6, wherein the sealing insert (26, 49) has a cover (41) rigidly connected to the frame (30),
wherein the cover (41) is arranged within a region bordered by the frame (30),
wherein the cover (41) has a cutout (42),
wherein the functional connection element (27) is arranged in the region of the cutout (42).

8. Functional module (60) according to Claim 7, wherein the cover (41) has at least one further cutout (43) .

9. Functional module (60) according to Claim 8, wherein the sealing insert (26, 49) has at least two retaining portions (44) rigidly connected to the frame (30),
wherein the retaining portions (44) extend in a direction perpendicular to the frame (30) and project into the functional housing (11),
wherein the retaining portions (44) are accessible through the further cutouts (43),
wherein the sealing insert (26, 49) is fixed to the retaining portions (44) on the functional housing (11).

10. Functional module (60) according to one of Claims 6 to 9,
wherein the functional connection element (27) does not project further out of the functional housing (11) than the frame (30) of the sealing insert (26, 49).

11. Sealing insert (26, 49) configured for a switchgear cabinet system (1) according to one of Claims 1 to 5 and a functional module (60) according to one of Claims 6 to 10.

## Revendications

1. Système d'armoire électrique (1)
comportant un module de base (2) et au moins un module fonctionnel (60),
le module fonctionnel (60) présentant un boîtier fonctionnel (11),
le boîtier fonctionnel (11) présentant une première ouverture traversante (25) sur un côté inférieur (12), un élément de connexion fonctionnel (27) du module fonctionnel (60) étant disposé dans le boîtier fonctionnel (11) et dans la région de la première ouverture traversante (25),
le module de base (2) présentant un boîtier de base (9), le boîtier de base (9) présentant une deuxième ouverture traversante (21) sur un côté supérieur (10),
un élément de connexion de base (22) du module de base (2) étant disposé dans le boîtier de base (9) et dans la région de la deuxième ouverture traversante (21),
le boîtier fonctionnel (11) s'appuyant, par le côté inférieur (12), contre le côté supérieur (10) du boîtier de base (9),
l'élément de connexion fonctionnel (27) et l'élément de connexion de base (22) venant en prise l'un dans l'autre et formant une interface,
**caractérisé en ce que** le système d'armoire électrique (1) présente un insert d'étanchéité (26, 49) comportant un cadre (30),
le cadre de l'insert d'étanchéité (26, 49) présentant une partie fonctionnelle (31) venant en prise dans le boîtier fonctionnel (11) et une partie de base (32) venant en prise dans le boîtier de base (9),
la partie fonctionnelle (31) du cadre (30) s'appuyant contre une paroi intérieure (33) du boîtier fonctionnel (11),
la partie de base (32) du cadre (30) s'appuyant contre une paroi (34), délimitant la deuxième ouverture traversante (21), du boîtier de base (9),
le cadre (30) de l'insert d'étanchéité (26, 49) présentant une première rainure (35) et une deuxième rainure (36),
la première rainure (35) étant formée de manière périphérique autour de la partie fonctionnelle (31) du cadre (30) et la deuxième rainure (36) étant formée de manière périphérique autour de la partie de base (32) du cadre (30),
un premier joint d'étanchéité (37) étant disposé dans la première rainure (35) et s'appuyant contre la paroi intérieure (33) du boîtier fonctionnel (11),
un deuxième joint d'étanchéité (38) étant disposé dans la deuxième rainure (36) et s'appuyant contre la paroi (34), délimitant la deuxième ouverture traversante (21), du boîtier de base (9),
le côté inférieur (12) du boîtier fonctionnel (11) présentant une troisième rainure (39) délimitant la première ouverture traversante (21),
un troisième joint d'étanchéité (40) étant disposé dans la troisième rainure (39) et s'appuyant contre le côté supérieur (10) du boîtier de base (9).

2. Système d'armoire électrique (1) selon la revendication 1,
l'insert d'étanchéité (26, 49) présentant un couvercle (41) relié rigidement au cadre (30),
le couvercle (41) étant disposé à l'intérieur d'une région délimitée par le cadre (30),
le couvercle (41) présentant un évidement (42), l'interface étant disposée dans la région de l'évidement (42) .

3. Système d'armoire électrique (1) selon la revendication 2,
le couvercle (41) présentant au moins un autre évidement (43) .

4. Système d'armoire électrique (1) selon la revendication 3,
l'insert d'étanchéité (26, 49) présentant au moins deux parties de retenue (44) reliées rigidement au cadre (30), les parties de retenue (44) s'étendant dans une direction perpendiculaire au cadre (30) et pénétrant dans le boîtier fonctionnel (11),
les parties de retenue (44) étant accessibles à travers les autres évidements (43),
l'insert d'étanchéité (26, 49) étant fixé au boîtier fonctionnel (11) au niveau des parties de retenue (44).

5. Système d'armoire électrique (1) selon l'une des revendications 1 à 4,
l'élément de connexion fonctionnel (27) ne faisant pas plus saillie hors du boîtier fonctionnel (11) que le cadre (30) de l'insert d'étanchéité (26, 49).

6. Module fonctionnel (60) configuré pour un système d'armoire électrique (1) selon la revendication 1,
le module fonctionnel (60) présentant un boîtier fonctionnel (11),
le boîtier fonctionnel (11) présentant une première ouverture traversante (25) sur un côté inférieur (12), un élément de connexion fonctionnel (27) du module fonctionnel (60) étant disposé dans le boîtier fonctionnel (11) et dans la région de la première ouverture traversante (25),
**caractérisé en ce que** le module fonctionnel (60) présente un insert d'étanchéité (26, 49) comportant un cadre (30), le cadre (30) de l'insert d'étanchéité (26, 49) présentant une partie fonctionnelle (31) venant en prise dans le boîtier fonctionnel (11) et une partie de base (32) disposée à l'extérieur du boîtier fonctionnel (11), la partie fonctionnelle (31) du cadre (30) s'appuyant contre une paroi intérieure (33) du boîtier fonctionnel (11),
le cadre (30) de l'insert d'étanchéité (26, 49) présentant une première rainure (35) et une deuxième rainure (36),
la première rainure (35) étant formée de manière périphérique autour de la partie fonctionnelle (31) de l'insert d'étanchéité (26, 49) et la deuxième rainure (36) étant formée de manière périphérique autour de la partie de base (32) de l'insert d'étanchéité (26, 49),
un premier joint d'étanchéité (37) étant disposé dans la première rainure (35) et s'appuyant contre la paroi intérieure (33) du boîtier fonctionnel (11),
un deuxième joint d'étanchéité (38) étant disposé dans la deuxième rainure (36),
le côté inférieur (12) du boîtier fonctionnel (11) présentant une troisième rainure (39) délimitant la première ouverture traversante (25),
un troisième joint d'étanchéité (40) étant disposé dans la troisième rainure (39).

7. Module fonctionnel (60) selon la revendication 6, l'insert d'étanchéité (26, 49) présentant un couvercle (41) relié rigidement au cadre (30),
le couvercle (41) étant disposé à l'intérieur d'une région délimitée par le cadre (30),
le couvercle (41) présentant un évidement (42), l'élément de connexion fonctionnel (27) étant disposé dans la région de l'évidement (42).

8. Module fonctionnel (60) selon la revendication 7, le couvercle (41) présentant au moins un autre évidement (43) .

9. Module fonctionnel (60) selon la revendication 8, l'insert d'étanchéité (26, 49) présentant au moins deux parties de retenue (44) reliées rigidement au cadre (30), les parties de retenue (44) s'étendant dans une direction perpendiculaire au cadre (30) et pénétrant dans le boîtier fonctionnel (11),
les parties de retenue (44) étant accessibles à travers les autres évidements (43),
l'insert d'étanchéité (26, 49) étant fixé au boîtier fonctionnel (11) au niveau des parties de retenue (44).

10. Module fonctionnel (60) selon l'une des revendications 6 à 9,
l'élément de connexion fonctionnel (27) ne faisant pas plus saillie hors du boîtier fonctionnel (11) que le cadre (30) de l'insert d'étanchéité (26, 49).

11. Insert d'étanchéité (26, 49) configuré pour un système d'armoire électrique (1) selon l'une des revendications 1 à 5 et un module fonctionnel (60) selon l'une des revendications 6 à 10.
